# EUROPÄISCHE PATENTANMELDUNG

(11) **EP 0 614 997 A1**
(43) Veröffentlichungstag der Anmeldung: **14.09.1994**
(21) Anmeldenummer: 93103736.0
(22) Anmeldetag: 09.03.1993
(51) Int. Cl.: C23C 14/34, H01J 37/34, B22F 7/06

(54) **Hochleistungstarget und Verfahren zur Herstellung eines derartigen Targets**

(71) Anmelder: THYSSEN INDUSTRIE AG, D-45128 Essen (DE)
(72) Erfinder: Kaiser, Hartmut, Dr.-Ing., W-4330 Mülheim/Ruhr (DE); Willems, Christian, Dipl.-Ing., W-4630 Bochum (DE)
(74) Vertreter: Dahlkamp, Heinrich-Leo, Dipl.-Ing.

(57) **Zusammenfassung**

Die Erfindung bezieht sich auf ein Hochleistungstarget, bei dem unter Wärmezufuhr im Vakuum dünne Schichten auf Substrate unter Aufopferung des Targets aufgedampft werden und auf ein Verfahren zur Herstellung eines derartigen Targets.

Erfindungsgemäß ist vorgesehen, daß
a.) das Targetmaterial in ein nicht abzusputterndes Targetträgermaterial mit hoher Wärmeleitfähigkeit eingebettet ist, wobei bis auf eine dünne Sicherheitstrennschicht zwischen Targetmaterial und Targetträgermaterial ein beim Sputtern möglichst vollständiges Abtragen des Targetmaterials vorgesehen ist, und
b.) in dem Targetträgermaterial ein Kühlkanalsystem entsprechend der Form des Targetmaterials angeordnet ist.

## Beschreibung

Die Erfindung bezieht sich auf ein Hochleistungstarget, bei dem unter Wärmezufuhr im Vakuum dünne Schichten auf Substrate unter Aufopferung des Targets aufgedampft werden und auf ein Verfahren zur Herstellung eines derartigen Targets.

Targets werden üblicherweise durch Schmieden, Gießen oder Walzen und auch durch heißisostatisches (HIP) Pressen als Platte, zum Beispiel ronden- oder rechteckförmig mit entsprechender Höhe hergestellt. Sie können auch zusätzlich auf einer gut wärmeleitfähigen Grundplatte zum Beispiel aus Kupfer angeordnet sein.

Aus der DE 38 12 379 A1 ist eine Zerstäubungskathode nach dem Magnetron-Prinzip mit einem Target bekannt, bei dem hinter dem Target ein verstellbares Magnetsystem zur Erzeugung von Plasmaringen auf der Oberfläche des Targets angeordnet ist. Das Target besteht dabei aus einer ebenen kreisförmigen Platte und ist mit einem topfförmigen, hohen Grundkörper durch Bonden, d. h. eine flächenhafte ebene Lötverbindung zwischen Target und Trägerplatte, verbunden.

In der DE 29 33 835 C2 ist darüber hinaus ein Verfahren zum Befestigen von in Scheiben- oder Plattenform vorliegenden Targetmaterialien auf Kühltellern beschrieben, wobei die Targetmaterialien mittels Plasmaspritzen mit einer Kupfer oder ähnlichen Schicht über eine dem Targetmaterial angepaßte Haftschicht lötbar beschichtet und anschließend mit dem Kühlteller durch Weichlöten verbunden ist.

Aufgrund anlagenspezifischer Besonderheiten wird bei der Dünnschichttechnologie der Sputterprozeß/Materialabtrag vom Target nur dort durchgeführt, wo das abgetragene Plasma mit Hilfe eines Magnetfeldes unmittelbar vor dem Target konzentriert wird. Durch diese sich einstellende Geometrie des Plasmas entsteht infolge des Targetmaterialabtrags eine charakteristische Sputtergeometrie (Vertiefung) an dem Target, d. h. nur hier erfolgt tatsächlich ein Materialabtrag. Der Rest des Targetmaterials wird nicht verbraucht. Entspricht die Tiefe der Sputtergeometrie nahezu der Target-(Plattenmaterial-) höhe, muß das Target ausgewechselt werden, wobei die Materialausbeute, bezogen auf das gesamte Targetmaterial, entsprechend gering ist. Da es sich bei dem Targetmaterial um besonders hochwertige und teure Stoffe handelt, die nur zum Teil und mit großem Aufwand wiederverwandt werden können beziehungsweise hohe Kosten bei der Entsorgung verursachen, liegt der Erfindung die Aufgabe zugrunde, eine neue Konstruktion für Hochleistungstargets vorzuschlagen, bei dem das Targetmaterial möglichst vollständig ausgenutzt wird und im übrigen preiswertere Trägermaterialien eingesetzt werden können und mit dem eine höhere Sputterleistung möglich ist.
Zur Lösung dieser Aufgabe wird ein gattungsgemäßes Hochleistungstarget mit den im Kennzeichen des Anspruchs 1 angegebenen Merkmalen vorgeschlagen. Die Unteransprüche 2 und 3 enthalten ergänzende Ausführungsformen dazu. In den Unteransprüchen 4 und 5 sind sinnvolle Verfahren zur Herstellung des erfindungsgemäßen Targets angegeben.

Die Erfindung geht davon aus, daß vor allem die selteneren und damit teuren Targetmaterialien nur noch dort angeordnet werden, wo sie beim Sputterprozeß auch abgetragen werden. Mit einer Kenntnis der anlagenspezifischen Sputtergeometrie ist hierbei zunächst genau zu lokalisieren, wo es zum Abtrag des Targetmaterials kommt, damit anschließend die Gesamtbereiche, in denen es nicht zu einem Absputtern kommt, mit preiswerterem, vorzugsweise auch gut wärmeleitendem Material, realisiert werden können.

Der Aspekt hoher Wärmeleitfähigkeit spielt auch im wirtschaftlichen Sinn eine Rolle, da zur weiteren Einsparung von Kosten, wie sie zum Beispiel Maschinenstunden verursachen, der meist langwierige Sputterprozeß durch Steigerung der Sputterleistung/Sputterrate beschleunigt und damit die dem Target zugeführte Energie erhöht werden müßte. Da jedoch ein Großteil der zugeführten Energie im Target in Wärme mit entsprechendem Temperaturanstieg umgesetzt und nicht ausreichend schnell abgeführt wird, ist die heutige Sputterleistung/Sputterrate begrenzt.

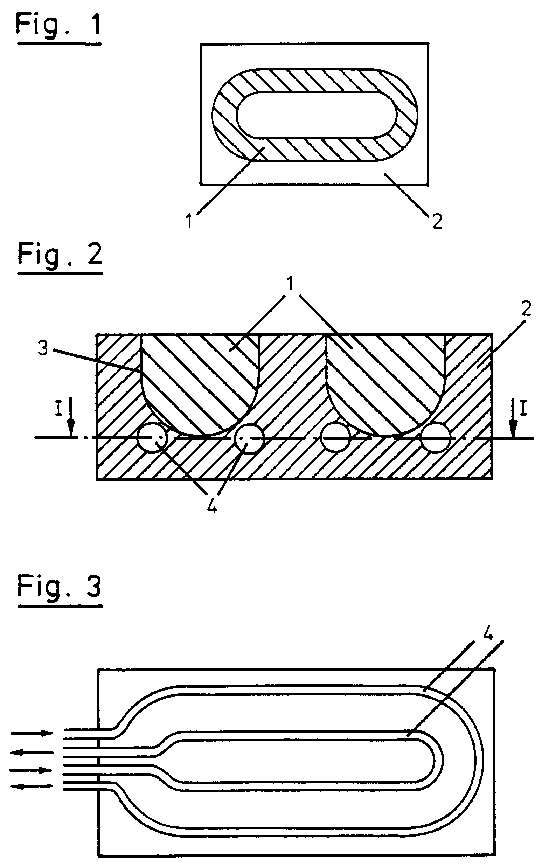

Die Erfindung schlägt daher ein kostengünstiges Hochleistungstarget vor, bei dem das eigentliche Targetmaterial fast vollständig abgesputtert werden kann und der Rest des Targets aus preiswerterem Trägermaterial besteht. Insbesondere sind entsprechend der Sputtergeometrie in dem Targetträgermaterial Kühlkanäle mit möglichst geringem Abstand zur Sputtergeometrie angeordnet.
Für die Herstellung erfindungsgemäßer, der Sputtergeometrie angepaßter Hochleistungstargets müssen folgende Kriterien erfüllt sein:
A.) Kenntnis der anlagenspezifischen Sputtergeometrie
B.) Festlegung von Art und Geometrie des abzusputternden Targetmaterials entsprechend A.)
C.) Festlegung der Geometrie des Kühlkanalsystems entsprechend A) und B).
Die Herstellung solcher Targets erfolgt vorzugsweise mittels bekannter pulvermetallurgischer Verfahren wie Pulveraufbereitung, Kapseltechnik, kalt- und heißisostatisches Pressen. Vorteile der pulvermetallurgischen Herstellung gegenüber den anderen Fertigungsverfahren sind dabei z. B. gleichmäßigere (isotropere) Gefüge, Seigerungsfreiheit, geringere Eigenspannungen durch die Möglichkeit, sprödes Targetmaterial in duktileres Grundmaterial einzubetten, gleichzeitiger Einbau und diffusive Bindung aller Targetkomponenten wie abzusputterndes Targetmaterial, duktiles und wärmeleitfähiges Targetgrundmaterial und Kühlkanalsystem.
Die Erfindung wird anhand der beigefügten Figuren 1 bis 3 beispielsweise näher erläutert.
Figur 1 zeigt ein erfindunggemäßes Hochleistungstarget in der Draufsicht.
Figur 2 ist ein senkrechter Schnitt von Figur 1.
Figur 3 ist ein waagerechter Schnitt nach der Linie I-I von Figur 2.
In den Figuren ist das Targetmaterial 1 mit entsprechender Sputtergeometrie dargestellt, das in das Targetträgermaterial 2 eingebettet ist. Am Übergang vom Targetmaterial 1 zum Targetträgermaterial 2 verbleibt aus Sicherheitsgründen beim absputtern des Trägermaterials eine dünne Zwischenschicht 3 aus Targetmaterial. Im Targetträgermaterial 2 befinden in der Nähe des Targetmaterials an die Sputtergeometrie angepaßt die Kühlkanäle 4 mit den entsprechenden Anschlüssen und Abführungen für die Kühlmedien.

### Bezugszeichenliste

- 1: Targetmaterial
- 2: Targetträgermaterial
- 3: Zwischenschicht
- 4: Kühlkanalsystem

## Patentansprüche

1. Hochleistungstarget, mit dem unter Wärmezufuhr im Vakuum dünne Schichten auf Substrate unter Aufopferung des Targets aufgedampft werden, dadurch gekennzeichnet, daß
a.) das Targetmaterial in ein nicht abzusputterndes Targetträgermaterial mit hoher Wärmeleitfähigkeit eingebettet ist, wobei bis auf eine dünne Sicherheitstrennschicht zwischen Targetmaterial und Targetträgermaterial ein beim Sputtern möglichst vollständiges Abtragen des Targertmaterials vorgesehen ist, und
b.) in dem Targetträgermaterial ein Kühlkanalsystem entsprechend der Form des Targetmaterials angeordnet ist.

2. Hochleistungstarget nach Anspruch 1, dadurch gekennzeichnet, daß das Targetmaterial bis auf die dem Substrat zugeordnete Seite vollständig vom Targetträgermaterial umgeben ist.

3. Hochleistungstarget nach Anspruch 1 oder 2, dadurch gekennzeichnet, daß bei einem Targetmaterial aus einer Komponente wie z.B. Titan, Chrom, Tantal, Zirkon, Niob oder mehrkomponentig aus Mischungen oder intermetallischen Verbindungen der Elemente Titan, Aluminium, Silizium, Vanadium, Zirkon, Wolfram, Tantal, Chrom, das Trägermaterial aus Aluminium, Kupfer oder Eisen beziehungsweise deren Legierungen besteht.

4. Verfahren zur Herstellung eines Hochleistungstargets gemäß den vorhergehenden Ansprüchen, dadurch gekennzeichnet, daß Target und Targetträger gleichzeitig durch heißisostatisches Pressen (HIP) hergestellt werden.

5. Verfahren nach Anspruch 4, dadurch gekennzeichnet, daß das Targetträgermaterial unter Berücksichtigung der werkstoffspezifischen Verträglichkeit zum Targetmaterial und zum vorgesehenen Kühlmedium festgelegt wird.
